(19) **Europäisches Patentamt / European Patent Office / Office européen des brevets**

(11) **EP 2 020 693 A2**

(12) # EUROPEAN PATENT APPLICATION

(43) Date of publication:
**04.02.2009 Bulletin 2009/06**

(21) Application number: **08158270.2**

(22) Date of filing: **13.06.2008**

(51) Int Cl.:
*H01L 51/05* (2006.01)

(84) Designated Contracting States:
**AT BE BG CH CY CZ DE DK EE ES FI FR GB GR HR HU IE IS IT LI LT LU LV MC MT NL NO PL PT RO SE SI SK TR**
Designated Extension States:
**AL BA MK RS**

(30) Priority: **31.07.2007 KR 20070076921**

(71) Applicant: **Samsung Electronics Co., Ltd.**
**Suwon-si**
**Gyeonggi-do 443-742 (KR)**

(72) Inventors:
• **Kim, Do Hwan,**
**Samsung Advanced Institute of Technology Mt.**
**Yongin-si,**
**Gyeonggi-do 449-712 (KR)**
• **Moon, Hyun Sik,**
**Samsung Advanced Institute of Technology Mt.**
**Yongin-si,**
**Gyeonggi-do 449-712 (KR)**

• **Koo, Bon Won,**
**Samsung Advanced Institute of Technology Mt.**
**Yongin-si,**
**Gyeonggi-do 449-712 (KR)**
• **Lee, Sang Yoon,**
**Samsung Advanced Institute of Technology Mt.**
**Yongin-si,**
**Gyeonggi-do 449-712 (KR)**
• **Hahn, Jung Seok,**
**Samsung Advanced Institute of Technology Mt.**
**Yongin-si,**
**Gyeonggi-do 449-712 (KR)**

(74) Representative: **Zijlstra, Robert Wiebo Johan**
**Elkington and Fife LLP**
**Prospect House**
**8 Pembroke Road**
**Sevenoaks, Kent TN13 1XR (GB)**

(54) **Organic Thin Film Transistor and Method of Manufacturing the Same**

(57) Disclosed are an organic thin film transistor and a method of manufacturing the same, in which a crystalline organic binder layer is on the surface of an organic insulating layer and source/drain electrodes or on the surface of the source/drain electrodes. The organic thin film transistor may be improved in two-dimensional geometric lattice matching and interface stability at the interface between the organic semiconductor and the insulating layer or at the interface between the organic semiconductor layer and the electrode, thereby improving the electrical properties of the device.

FIG. 3

## Description

Example embodiments relate to an organic thin film transistor (OTFT) having improved interface properties and a method of manufacturing the same, and more particularly, to an OTFT having improved device properties, in which a crystalline organic binder layer is formed on the surface of an organic insulating layer and source/drain electrodes or on the surface of the source/drain electrodes, thus improving two-dimensional geometric lattice matching and interface stability at the interface between an organic semiconductor and an insulator, thereby improving device properties, and to a method of manufacturing the same.

A thin film transistor (TFT) may be used as a switching device for controlling the operation of each pixel and a driving device for driving each pixel in a flat panel display, for example, a liquid crystal display (LCD) or an electroluminescent display (ELD). In addition, such a TFT may be applied to smart cards or plastic chips for inventory tags.

The semiconductor layer of the TFT may be typically formed of an inorganic semiconductor material, for example, silicon (Si). However, according to the recent trend toward the manufacture of relatively large, inexpensive, and flexible displays, there may be a need to replace an expensive inorganic material, requiring a high-temperature vacuum process, with an organic semiconductor material. Thus, research into the use of organic film as the semiconductor layer in OTFTs is being conducted.

An OTFT may be composed of a plurality of layers, including a substrate, a gate electrode, an insulating layer, source/drain electrodes, and an organic semiconductor, and such individual layers may have interfaces therebetween. In order to maximize or increase the properties of the OTFT using a crystalline organic semiconductor as a channel material, the control of the electrical properties between the organic semiconductor layer and the electrode or between the organic semiconductor layer and the insulating layer and of the microstructure of the interface may be essentially required. Accordingly, a process of forming a type of interlayer material may be regarded as important, but satisfactory research results have not yet been reported. In the OTFT, the organic semiconductor layer mostly may have a crystal orientation structure, whereas the electrode or organic insulating layer has no crystal orientation structure, and thus the properties may suffer due to lattice mismatching at the interface between the organic semiconductor layer and the electrode or between the organic semiconductor layer and the insulating layer.

An organic silane compound, which may be a conventional interlayer material between the organic semiconductor layer and the insulating layer, may be commonly used to make the surface of the insulating layer hydrophobic. However, because this material may not be crystalline, there may be a limitation in the use thereof in controlling the crystal orientation and crystallinity of the crystal line organic semiconductor. Further, such an interlayer material may be problematic in that it may be difficult to introduce into the interface between the organic semiconductor layer and the metal electrode. Alternatively, a thiol-based interlayer material may be presently applied to the surface of the electrode, but may be disadvantageous because the use thereof undesirably leads to a reduction in processability when manufacturing the OTFT.

Accordingly, example embodiments have been devised keeping in mind the above problems occurring in the related art, and provided may be an OTFT having improved device properties, in which a functional organic nano binder, which may be crystalline, may be used as an interlayer material, instead of a conventional amorphous interlayer material, and thereby, interface interaction force between the organic semiconductor and the electrode of the OTFT may be precisely controlled, thus minimizing or decreasing a hole injecting barrier and realizing two-dimensional geometric lattice matching between the organic semiconductor and the insulating layer, consequently optimizing or increasing the crystal orientation of the organic semiconductor.

Example embodiments provide a method of manufacturing an OTFT, in which a hydrophilic end group and a fused aromatic ring for crystallinity may be introduced and a hydrophilic organic solvent may be used, thereby improving interface stability between the organic insulating layer and the organic semiconductor of the OTFT and between the source/drain electrodes and the organic semiconductor of the OTFT, and also increasing processability.

According to example embodiments, an OTFT may include a substrate, a gate electrode, an organic insulating layer, source/drain electrodes, an organic semiconductor layer, and a crystalline organic binder layer, on the surface of the organic insulating layer and the source/drain electrodes or on the surface of the source/drain electrodes.

The crystalline organic binder layer may be formed using a crystalline organic binder having a $C_{5-12}$ aromatic backbone constituting a crystalline structure, one end of the backbone having a hydrophilic functional group, and the other end of the backbone having a functional group for controlling a dipole moment, and may have a thickness ranging from about 20 Å to about 10 nm.

The aromatic backbone may be selected from the group consisting of benzene, naphthalene, anthracene, tetracene, and n-phenylene (wherein n is about 2 - about 6), and the hydrophilic functional group may be selected from a group consisting of -COOH, -SOOH, and -POOOHH. Further, the functional group for controlling a dipole moment may be selected from a group consisting of F, -OH, - $NO_2$, -$NH_2$, -SH, -$CH_3$, -CF, -Cl and a phenyl group. Examples of the crystalline organic binder may include, but are not limited to, aminobenzoic acid, nitrobenzoic acid, chlorobenzoic acid, fluorobenzoic acid, hydroxybenzoic acid, alkyloxybenzoic acid, alkylbenzoic acid, phenoxybenzoic acid, and iodobenzoic acid.

In addition, according to example embodiments, a method of manufacturing an OTFT including a substrate, a gate electrode, an organic insulating layer, source/drain electrodes, and an organic semiconductor layer on a substrate, may include subjecting a surface of the organic insulating layer and the source/drain electrodes, having respective banks, to oxygen plasma treatment, and applying a crystalline organic binder coating solution on the surface that may be subjected to oxygen plasma treatment, thus forming a crystalline organic binder layer.

In the method according to example embodiments, the crystalline organic binder layer may be formed only on the surface of the source/drain electrodes. In this case, subjecting the surface of the organic insulating layer to surface treatment using a hydrophobic compound may be further included before surface treatment using the crystalline organic binder coating solution.

Example embodiments will be more clearly understood from the following detailed description, taken in conjunction with the accompanying drawings. FIGS. 1-6 depict non-limiting example embodiments described herein.

FIG. 1A is a schematic sectional view illustrating the OTFT according to example embodiments;
FIG. 1B is a schematic sectional view illustrating the OTFT according to example embodiments;
FIG. 1C is a schematic sectional view illustrating the OTFT according to example embodiments;
FIG. 2 is a schematic view illustrating the state of crystal orientation of the crystalline organic binder ofthe crystalline organic binder layer, according to example embodiments;
FIG. 3 is a schematic view illustrating the process of manufacturing the OTFT using the crystalline organic binder, according to example embodiments;
FIGS. 4A to 4D are polarization micrographs illustrating the interface between the organic insulating layer and the organic semiconductor of the OTFT obtained in Examples 2 and 3;
FIG. 5 is a polarization micrograph illustrating the crystalline organic binder selectively applied on the electrode; and
FIG. 6 is I-V curves ofthe OTFTs obtained in Examples 1-3 and Comparative Example 2.

It should be noted that these Figures are intended to illustrate the general characteristics of methods, structure and/or materials utilized in certain example embodiments and to supplement the written description provided below. These drawings are not, however, to scale and may not precisely reflect the precise structural or performance characteristics of any given embodiment, and should not be interpreted as defining or limiting the range of values or properties encompassed by example embodiments. For example, the relative thicknesses and positioning of molecules, layers, regions and/or structural elements may be reduced or exaggerated for clarity. The use of similar or identical reference numbers in the various drawings is intended to indicate the presence of a similar or identical element or feature.

Hereinafter, example embodiments will be described in detail with reference to the attached drawings. Reference now should be made to the drawings, in which the same reference numerals are used throughout the different drawings to designate the same or similar components. In the drawings, the thicknesses and widths of layers are exaggerated for clarity. Example embodiments may, however, be embodied in many different forms and should not be construed as limited to example embodiments set forth herein. Rather, these example embodiments are provided so that this disclosure will be thorough and complete, and will fully convey the scope of example embodiments to those skilled in the art.

It will be understood that when an element is referred to as being "connected" or "coupled" to another element, it can be directly connected or coupled to the other element or intervening elements may be present. In contrast, when an element is referred to as being "directly connected" or "directly coupled" to another element, there are no intervening elements present. Like numbers indicate like elements throughout. As used herein the term "and/or" includes any and all combinations of one or more of the associated listed items.

It will be understood that, although the terms "first", "second", etc. may be used herein to describe various elements, components, regions, layers and/or sections, these elements, components, regions, layers and/or sections should not be limited by these terms. These terms are only used to distinguish one element, component, region, layer or section from another element, component, region, layer or section. Thus, a first element, component, region, layer or section discussed below could be termed a second element, component, region, layer or section without departing from the teachings of example embodiments.

Spatially relative terms, such as "beneath," "below," "lower," "above," "upper" and the like, may be used herein for ease of description to describe one element or feature's relationship to another element(s) or feature(s) as illustrated in the figures. It will be understood that the spatially relative terms are intended to encompass different orientations of the device in use or operation in addition to the orientation depicted in the figures. For example, if the device in the figures is turned over, elements described as "below" or "beneath" other elements or features would then be oriented "above" the other elements or features. Thus, the exemplary term "below" can encompass both an orientation of above and below. The device may be otherwise oriented (rotated 90 degrees or at other orientations) and the spatially relative descriptors used herein interpreted accordingly.

The terminology used herein is for the purpose of describing particular embodiments only and is not intended to be limiting of example embodiments. As used herein, the singular forms "a," "an" and "the" are intended to include the plural forms as well, unless the context clearly indicates otherwise. It will be further understood that the terms "comprises" and/or "comprising," when used in this specification, specify the presence of stated features, integers, steps, operations, elements, and/or components, but do not preclude the presence or addition of one or more other features, integers, steps, operations, elements, components, and/or groups thereof

Example embodiments are described herein with reference to cross-sectional illustrations that are schematic illustrations of idealized embodiments (and intermediate structures) of example embodiments. As such, variations from the shapes of the illustrations as a result, for example, of manufacturing techniques and/or tolerances, are to be expected. Thus, example embodiments should not be construed as limited to the particular shapes of regions illustrated herein but are to include deviations in shapes that result, for example, from manufacturing. For example, an implanted region illustrated as a rectangle will, typically, have rounded or curved features and/or a gradient of implant concentration at its edges rather than a binary change from implanted to non-implanted region. Likewise, a buried region formed by implantation may result in some implantation in the region between the buried region and the surface through which the implantation takes place. Thus, the regions illustrated in the figures are schematic in nature and their shapes are not intended to illustrate the actual shape of a region of a device and are not intended to limit the scope of example embodiments.

Unless otherwise defined, all terms (including technical and scientific terms) used herein have the same meaning as commonly understood by one of ordinary skill in the art to which example embodiments belong. It will be further understood that terms, such as those defined in commonly-used dictionaries, should be interpreted as having a meaning that is consistent with their meaning in the context of the relevant art and will not be interpreted in an idealized or overly formal sense unless expressly so defined herein.

According to example embodiments, the OTFT may include a substrate, a gate electrode, an organic insulating layer, source/drain electrodes, an organic semiconductor layer, and a crystalline organic binder layer, which may be formed on the surface of the organic insulating layer and the source/drain electrodes or on the surface of the source/drain electrodes.

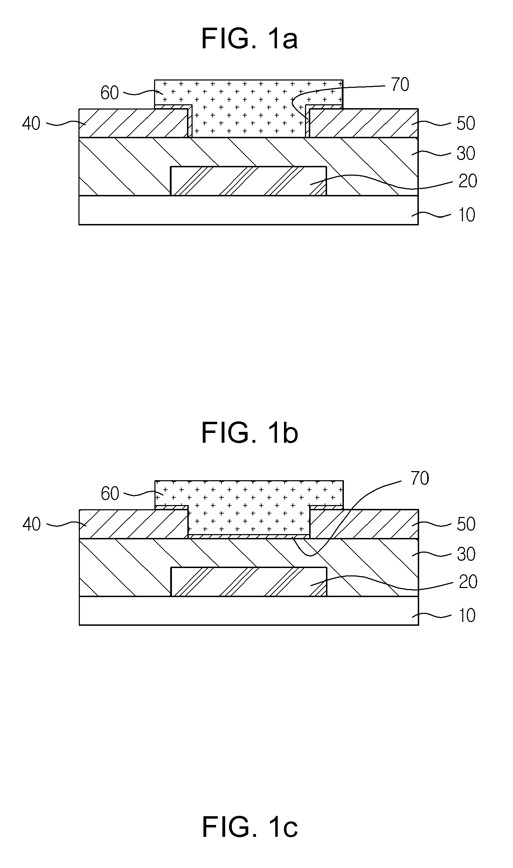

FIGS. 1A to 1C is schematic sectional views illustrating the OTFT having the crystalline organic binder layer, according to example embodiments. As illustrated in the OTFT of FIG. 1A, according to example embodiments, the crystalline organic binder layer 70 may be formed on the surface of the organic insulating layer 30 and the source/drain electrodes 40, 50. When the source electrode 40 and the drain electrode 50 may be formed on the organic insulating layer 30, the crystalline organic binder layer 70, composed of a crystalline organic binder, may be formed in order to improve two-dimensional geometric lattice matching between the organic insulating layer 30 and the organic semiconductor layer 60 and between the organic semiconductor layer 60 and the electrodes 40, 50, and to improve the interface stability between the electrode and the organic semiconductor. The organic insulating layer 30, source/drain electrodes 40, 50, organic semiconductor layer 60, and crystalline organic binder layer 70 are all formed on a substrate 10 and a gate electrode 20.

As illustrated in the OTFT of FIG. 1B, according to example embodiments, the crystalline organic binder layer 70 may be formed only on the surface of the source/drain electrodes 40, 50 adjoining the organic semiconductor layer 60. In the case of a top contact type OTFT of FIG. 1C, according to example embodiments, the crystalline organic binder layer 70 may be formed between the organic insulating layer 30 and the organic semiconductor layer 60.

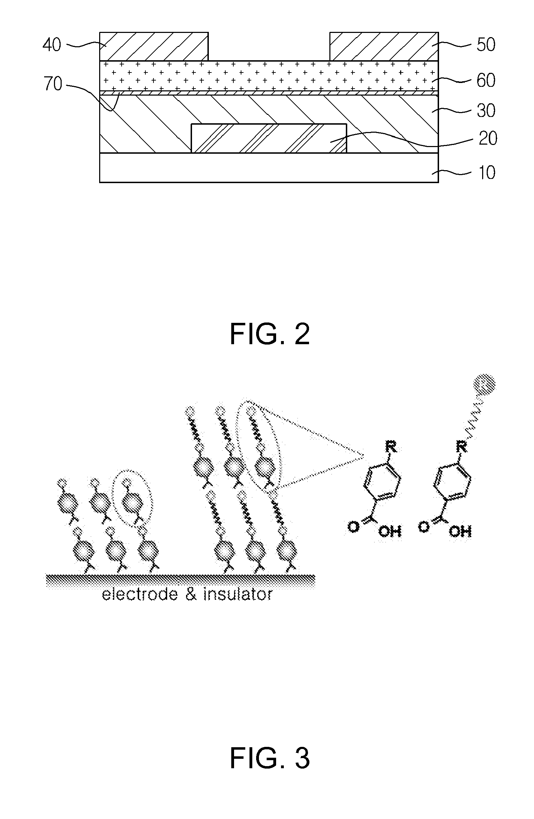

FIG. 2 is a schematic view illustrating the crystalline organic binder layer formed on the surface of the electrode and the organic insulating layer in the OTFT, according to example embodiments. As is seen in FIG. 2, the backbone of the crystalline organic binder may include a functional group constituting a crystalline structure, in which one end of such a backbone may be connected with a hydrophilic functional group, and the other end thereof may be connected with a functional group for controlling various dipole moments.

Hence, preparing a hydrophilic organic binder solution, which may be applied only on the hydrophilic portion through such functional groups, may be possible. The crystalline structure of the organic binder may be controlled such that a two-dimensional geometric lattice between the organic nano binder and the crystalline organic semiconductor may be realized, thereby precisely controlling the crystal orientation of the organic semiconductor layer and the interface interaction force at the interface between the insulating layer and the organic semiconductor layer or between the electrode and the organic semiconductor layer.

As seen in FIG. 2, the crystalline organic binder layer, which may be formed on the surface of the organic insulating layer or source/drain electrodes, may be provided in the form of a monolayer or multilayer structure due to the crystalline organic binder. The crystalline organic binder layer 70 may have a thickness ranging from tens of Å to tens of nm, for example, from about 20 Å to about 10 nm.

In the crystalline organic binder layer, the hydrophilic functional group of the crystalline organic binder molecule may be arranged toward the electrode or organic insulating layer, whereas the functional group for controlling the dipole moment may be arranged toward the organic semiconductor layer. Thus, such a crystalline organic binder layer, which may consist of polycrystals and may exhibit improved crystallinity, may play a role in aiding the crystal orientation of the organic semiconductor layer when the organic semiconductor layer may be formed on the electrode or organic insulating layer. Furthermore, the crystalline organic binder layer may have a relatively highly ordered structure to facilitate the injection of holes, thus improving charge mo bility.

In example embodiments, the aromatic backbone of the crystalline organic binder may not be particularly limited, as long as it may be a functional group that constitutes crystals able to control the crystal orientation of the semiconductor of the organic semiconductor layer and the contact resistance thereof, and examples thereof may include, but are not limited to, benzene, naphthalene, anthracene, tetracene, and n-phenylene (where n is about 2 - about 6). Further, specific examples of the aromatic group constituting the backbone of the crystalline organic binder may include, but are not limited to, benzene, thiophene, pyrrole, 2H-pyran, pyridine, oxazole, isoxazole, thiazole, isothiazole, furazane, imidazole, pyrazole, pyrazine, pyrimidine, pyridazine, pentalene, indene, indolizine, 4H-quinolizine, naphthalene, azulene, benzofuran, isobenzofuran, 1-benzothiophene, 2-benzothiophene, indole, isoindole, 2H-chromene, 1H-2-benzopyrane, quinoline, isoquinoline, 1,8-naphthyridine, benzimidazole, 1H-indazole, benzoxazole, benzothiazole, quinoxaline, quinazoline, cinnoline, pteridine, purine, phthalazine, heptalene, biphenylene, acenaphthylene, fluorene, phenalene, phenanthrene, anthracene, carbazole, xanthene, acridine, phenanthridine, and perinidine.

The hydrophilic functional group, which may be connected to the end of the backbone of the crystalline organic binder, may not be particularly limited, and may be -COOH, -SOOH, and -POOOHH. Further, the functional group (R) for controlling the dipole moment, which may be present in the other end of the backbone of the crystalline organic nano binder, may be selected from the group consisting of F, -OH, - $NO_2$, -$NH_2$, -SH, -$CH_3$, -CF, -Cl and a phenyl group. When such an end group (R) may be controlled, the surface dipole moment may be changed, thus enabling control of the threshold voltage of the OTFT. Examples of the crystalline organic binder may include, but are not limited to, aminobenzoic acid, nitrobenzoic acid, chlorobenzoic acid, fluorobenzoic acid, hydroxybenzoic acid, alkyloxybenzoic acid, alkylbenzoic acid, phenoxybenzoic acid, and iodobenzoic acid.

The OTFT according to example embodiments may have improved device properties and may thus be variously applied to plastic-based devices, for example, active driving elements of organic electroluminescent devices, smart cards, and plastic chips for inventory tags. The structure of the OTFT according to example embodiments is not particularly limited, and a predetermined or given structure, including a top contact structure and/or a bottom contact structure, may be provided. Examples of the structure of an OTFT that may be manufactured using the organic insulating layer according to example embodiments are schematically illustrated in FIGS. 1A to 1C. FIGS. 1A and 1B are schematic sectional views illustrating the bottom contact type OTFT, and FIG. 1C is a schematic sectional view illustrating the top contact type OTFT.

For example, the OTFT according to example embodiments may have either a structure in which a gate electrode 20, an organic insulating layer 30, source/drain electrodes 40, 50, and an organic semiconductor layer 60 may be sequentially formed on a substrate 10, as illustrated in FIGS. 1A and 1B, or a structure in which a gate electrode 20, an organic insulating layer 30, an organic semiconductor layer 60, and source/drain electrodes 40, 50 may be sequentially formed on a substrate 10, as illustrated in FIG. 1C. In the OTFT according to example embodiments, the crystalline organic binder layer 70 may be formed on the surface of the organic insulating layer 30 and the source/drain electrodes 40, 50, as seen in FIG. 1A, or may be formed on the surface of the source/drain electrodes 40, 50, as seen in FIG. 1B.

The material for the substrate 10 may be selected from among various insulating materials. Examples thereof may include, but are not limited to, glass, silicon, polyethylenenaphthalate (PEN), polyethyleneterephthalate (PET), polycarbonate, polyvinylbutyral, polyacrylate, polyimide, polynorbornene, and polyethersulfone (PES). In particular, the use of a polymer compound film as the substrate may be advantageous because an organic semiconductor apparatus that is lightweight and flexible may be manufactured.

For the gate electrode 20, typical materials may be used without limitation, for example, one or more selected from among metals, including gold (Au), silver (Ag), aluminum (Al), nickel (Ni), molybdenum (Mo), tungsten (W), and chromium (Cr), alloys thereof (e.g., molybdenum/tungsten (Mo/W) alloy), metal oxides, including indium tin oxide (ITO) and indium zinc oxide (IZO), and conductive polymers, including polythiophene, polyaniline, polyacetylene, polypyrrole, polyphenylenevinylene, and a mixture of PEDOT (polyethylenedioxythiophene)/PSS (polystyrenesulfonate). As the method of forming the gate electrode, a deposition method well known in the art, for example, sputtering or vacuum deposition, and a solution process, for example, spin coating, may be used without limitation, and furthermore, patterning may be conducted according to a typical method, if necessary. The thickness of the gate electrode may be appropriately set depending on the end use and need, but may range from about 500 Å to about 2,000 Å.

For the organic insulating layer 30, a typical insulating layer having a high dielectric constant may be used, and specific examples thereof may include, but are not limited to, a ferroelectric insulating layer selected from the group consisting of $Ba_{0.33}Sr_{0.66}TiO_3$(BST), $Al_2O_3$, $Ta_2O_5$, $La_2O_5$, $Y_2O_3$ and $TiO_2$, an inorganic insulating layer selected from the group consisting of $PbZr_{0.33}Ti_{0.66}O_3$ (PZT), $Bi_4Ti_3O_{12}$, $BaMgF_4$, $SrBi_2(TaNb)_2O_9$, $Ba(ZrTi)O_3$ (BZT), $BaTiO_3$, $SrTiO_3$, $Bi_4Ti_3O_{12}$, $SiO_2$, $SiN_x$ and AlON, and an organic insulating layer including polyimide, benzenecyclobutene (BCB), parylene, polyacrylate, polyvinylalcohol and polyvinylphenol. The thickness of the organic insulating layer may be appropriately set depending on the end use and need, and may range from about 1000 Å to about 7000 Å. Although the method of forming the organic insulating layer may not be particularly limited, the method may include, for example, vacuum deposition, and a solution process, including spin coating, ink jetting, or printing. Further, soft baking may be conducted at about 60°C ~ 150°C for about 1 minute ~ about 10 minutes, and hard baking may be conducted at about 100°C ~ about 200°C for a period of time ranging from about 30 minutes to about 3 hours, if necessary.

The organic insulating layer 30 may be formed of a silane-based organic/inorganic hybrid material. Such a silane-based organic/inorganic hybrid material may be an organic silane compound containing a multiple bond, or a polymer obtained by subjecting the organic silane compound containing a multiple bond to hydrolysis and condensation in the presence of an acid or base catalyst.

For the organic semiconductor layer 60, a typical material may be used, and specifically, derivatives, including pentacene, copper phthalocyanine, polythiophene, polyaniline, polyacetylene, polypyrrole, and polyphenylene vinylene, may be used alone or in mixtures of two or more thereof, but example embodiments are not limited thereto. The molecular weight and degree of polymerization may be appropriately set depending on the end use and need. For the source/drain electrodes 40, 50, a typical metal may be used, and specific examples thereof may include, but are not limited to, gold (Au), silver (Ag), aluminum (Al), nickel (Ni), and indium tin oxide (ITO).

In addition, example embodiments pertain to a method of manufacturing the OTFT using the crystalline organic binder solution. FIG. 3 schematically illustrates the process of manufacturing the OTFT, according to example embodiments. According to example embodiments, when manufacturing the OTFT including a substrate, a gate electrode, an organic insulating layer, source/drain electrodes, and an organic semiconductor layer, the surface of the organic insulating layer and source/drain electrodes, having respective banks, may be subjected to oxygen plasma treatment, after which a crystalline organic binder layer may be formed on the surface and subjected to oxygen plasma treatment using a crystalline organic binder. As such, the usable crystalline organic binder may be a compound which has a $C_{5\sim12}$ aromatic backbone, able to constitute a crystalline structure, and may have a hydrophilic functional group at one end of the backbone and a functional group for controlling a dipole moment at the other end thereof.

According to example embodiments, the method of manufacturing the OTFT may further include treating the surface of the organic insulating layer with a hydrophobic compound before the surface treatment using the crystalline organic binder. In the method according to example embodiments, the crystalline organic binder may be applied on the surface of the source/drain electrodes or on the surface of the organic insulating layer and the source/drain electrodes, thus forming the crystalline organic binder layer, in order to control the interface stability and contact resistance between the organic insulating layer and the organic semiconductor layer and/or between the organic semiconductor layer and the electrode.

Describing the method according to example embodiments in greater detail, in the case where the crystalline organic binder may be applied on the insulating layer and the source/drain electrodes at the same time, as represented by 'process I' in FIG. 3, an OTFT in which a hydrophobic bank material may be present is first subjected to oxygen plasma treatment. The bank may be a bank for the semiconductor layer or a bank for the source/drain electrodes, and may be formed through a typical method with the use of typical material for the formation of a bank, which is known in the field of conventional OTFTS, without limitation.

After the oxygen plasma treatment, the bank portion may be still hydrophobic, whereas the electrode portion and the insulating layer portion may be hydrophilic. Thereafter, when a hydrophilic solution, in which the crystalline organic binder may be dissolved, is subjected to spin coating on the surface of the organic insulating layer and the electrode, and then subjected to oxygen plasma treatment, the channel portion between the source electrode and the drain electrode on the hydrophilic organic insulating layer and the surface of the electrode may be naturally coated. The portion where the crystalline organic binder layer is formed may be printed with the crystalline organic semiconductor to thus form the organic semiconductor layer, thereby completing the OTFT. In coating the surface of the organic insulating layer and the source/drain electrodes or the surface of the source/drain electrodes with the crystalline organic binder, the hydrophilic coating solution of the crystalline organic binder, including the crystalline organic binder and the hydrophilic solvent, may be applied and may then be dried.

Examples of the method of applying the crystalline organic binder coating solution may include, but are not limited to, printing, screen printing, spin coating, dipping, ink jetting, vacuum deposition, and thermal deposition. Further, after the application, baking may be additionally conducted, if necessary. This baking may be conducted at about 20°C ~ about 300°C for a period of time ranging from about 10 minutes to about 5 hours, but example embodiments are not limited thereto. According to example embodiments, the crystalline organic binder layer may have a thickness ranging from about 20 Å to about 10 nm.

The aromatic backbone of the crystalline organic binder may be selected from among benzene, naphthalene, anthracene, tetracene, and n-phenylene (wherein n is about 2 - about 6), and the hydrophilic functional group may be selected from among -COOH, -SOOH, and -POOOHH. The functional group for controlling the dipole moment may be selected from among F, -OH, -NO$_2$, -NH$_2$, - SH, -CH$_3$, -CF, -Cl and a phenyl group, but example embodiments are not limited thereto. Examples of the crystalline organic binder may include, but are not limited to, aminobenzoic acid, nitrobenzoic acid, chlorobenzoic acid, fluorobenzoic acid, hydroxybenzoic acid, alkyloxybenzoic acid, alkylbenzoic acid, phenoxybenzoic acid, and iodobenzoic acid. Examples of the hydrophilic solvent used to prepare the hydrophilic coating solution of the crystalline organic binder may include, but are not limited to, water, alcohol, acetonitrile, and chloroform.

In the case where the crystalline organic binder may be selectively applied only on the surface of the electrode, as represented by 'process II' in FIG. 3, an OTFT, in which a hydrophobic bank material is present, may be first subjected to oxygen plasma treatment. After the oxygen plasma treatment, the bank portion may still be hydrophobic, whereas the electrode portion and the insulating layer portion may be hydrophilic. Then, a hydrophobic compound solution may be applied on the insulating layer portion, thus making the insulating layer portion hydrophobic, in addition to the bank portion. Finally, when a hydrophilic solution in which the crystalline organic binder is dissolved is subjected to spin coating, the organic binder coating solution may be naturally applied only on the surface of the source/drain electrodes, which may be hydrophilic. The portion thus surface treated selectively with the crystalline organic binder may be printed with the crystalline organic semiconductor to thus form the organic semiconductor layer, thereby completing the OTFT. Although the hydrophobic compound may not be particularly limited, the hydrophobic compound may include, for example, an organic silane compound. Examples of the organic silane compound may include, but are not limited to, octadecyltrichlorosilane, octyltrichlorosilane, propyltrichlorosilane, pentyltrichlorosilane, heptyltrichlorosilane, and dodecyltrichlorosilane.

A better understanding of example embodiments may be obtained in light of the following examples, which are set forth to illustrate, but are not to be construed to limit example embodiments.

Example 1

First, on a cleaned glass substrate, a molybdenum/tungsten (Mo/W) alloy was deposited through sputtering, thus forming a gate electrode about 2,000 Å thick. An organic/inorganic hybrid insulating layer (OETS: C=C-C-C-C-C-C-C-Si+PVB+Ti(OBu)$_4$) was applied thereon through spin coating at about 1500 rpm for about 50 seconds, pre-annealed at about 70°C for about 2 minutes, and then baked at about 200°C for about 1 hour, thus forming an organic insulating layer about 7,000 Å thick.

Au was deposited to a thickness of about 700 Å on the organic insulating layer through sputtering using a shadow mask having a channel length of about 100 $\mu$m and a channel width of about 1 mm, thus forming source/drain electrodes. Thereafter, in order to selectively apply a solution of a crystalline organic nano binder and a solution of an organic semiconductor, a hydrophobic bank material [a protective film-forming composition, including a copolymer of perfluoropolyether and a photosensitive polymer, and a photo curing agent] was formed (thickness: about 1 $\mu$m, contact angle: about 105°).

Next, in order to selectively apply the crystalline nano binder on the electrode, the OTFT in which the hydrophobic bank material may be present was subjected to oxygen plasma treatment for about 30 seconds. Subsequently, the insulating layer portion was coated with a hydrophobic compound, for example, an octyltrichlorosilane solution (about 10 mM), and then spin coated with the crystalline nano binder, for example, a solution of nitrobenzoic acid (NBA) in ethanol (concentration: about 0.1 wt% ~ about 1 wt%).

Finally, a poly(oligothiophene-thiazole) derivative (m.w.: about 20000 g/mol, degree of polymerization: about 20) was dissolved to a concentration of about 1 wt% in chlorobenzene to prepare an organic semiconductor solution, after which the organic semiconductor solution thus prepared was applied to a thickness of about 7000 Å on the organic insulating layer through spin coating at about 1,000 rpm, and was then baked at about 100°C for about 1 hour in a nitrogen atmosphere, thus forming an organic semiconductor layer, thereby manufacturing an OTFT device. Forming the organic semiconductor (pentacene) layer for deposition was conducted under conditions of a vacuum level of about 2x10$^{-6}$torr, a substrate temperature of about 80°C, and a deposition rate of about 0.3 Å/sec.

Example 2

An OTFT was manufactured in the same manner as in Example 1, with the exception that the octyltrichlorosilane solution (about 10 mM) was not applied on the insulating layer portion, such that the insulating layer and the electrode were coated with the crystalline organic binder at the same time, unlike Example 1, in which the crystalline organic binder composition was selectively applied only on the electrode and the properties thereof were measured. The results are shown in Table 1 below.

Example 3

An OTFT was manufactured in the same manner as in Example 1, with the exception that aminobenzoic acid (ABA) was used as the crystalline organic binder, and the properties thereof were measured. The results are shown in Table 1 below.

Comparative Example 1

An OTFT was manufactured in the same manner as in Example 1, with the exception that neither the electrode nor the insulating layer were surface treated with the crystalline binder coating solution, and the electrical properties thereof were measured. The results are shown in Table 1 below.

Comparative Example 2:

An OTFT was manufactured in the same manner as in Example 1, with the exception that the surface of the insulating layer was treated with octyltrichlorosilane, and the properties thereof were measured. The results are shown in Table 1 below.

Experimental Example 1

In order to evaluate the electrical properties of the OTFTs according to example embodiments, using a Keithley semiconductor analyzer (4200-SCS), the driving properties, including charge mobility and threshold voltage, of the OTFTs obtained in Examples 1-3 and Comparative Examples 1 and 2 were measured as follows.

Charge Mobility

The charge mobility was calculated using the following current equation for the saturation region. For example, the current equation was converted into a graph of $(I_{SD})^{1/2}$ and $V_G$, and the charge mobility was calculated from the slope of the converted graph:

$$I_{SD} = \frac{WC_0}{2L} \mu (V_G - V_T)^2$$

$$\sqrt{I_{SD}} = \sqrt{\frac{\mu C_0 W}{2L}} (V_G - V_T)$$

$$slope = \sqrt{\frac{\mu C_0 W}{2L}}$$

$$\mu_{FET} = (slope)^2 \frac{2L}{C_0 W}$$

wherein $I_{SD}$ is the source-drain current, $\mu$ or $\mu_{FET}$ is the charge mobility, $C_o$ is the insulating layer capacitance, W is the channel width, L is the channel length, $V_G$ is the gate voltage, and $V_T$ is the threshold voltage.

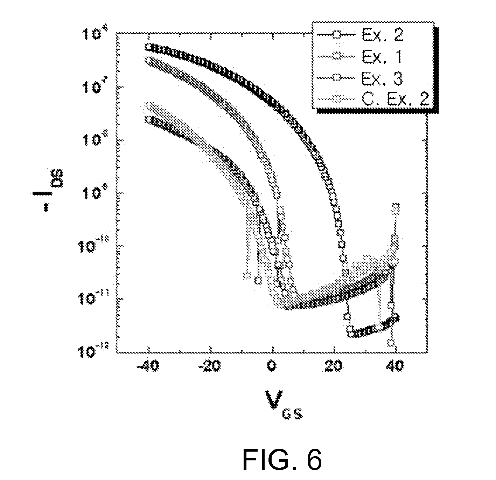

In the OTFTs manufactured in Comparative Example 2 and Examples 1~3, I-V properties were evaluated. The results are shown in FIG. 6. As shown in FIG. 6, from the results of Examples 1 and 2, in which the OTFT was manufactured by forming the crystalline organic binder layer and then applying the organic polymer semiconductor, on-current and field effect mobility may be increased (about $2 \times 10^{-8}$A -> about $6 \times 10^{-7}$A). Such an increase in the on-current and field effect mobility may be based on two-dimensional geometric lattice matching between the organic semiconductor and the crystalline organic binder, interface stability between the electrode and the organic semiconductor, and decreased contact resistance therebetween. Further, the threshold voltage of the OTFT may be controlled by adjusting the end group (R) of the crystalline organic binder.

Table 1

|  | Ion (A) | Ioff (A) | Charge Mobility (cm/Vs) | Threshold Voltage (V) |
|---|---|---|---|---|
| C.Ex. 1 | 2.12E-08 | 7.86E-012 | 0.001 | -1.5 |
| C.Ex. 2 | 4.23E-08 | 7.01E-012 | 0.002 | -8.6 |
| Ex. 1 | 3.05E-07 | 7.28E-012 | 0.02 | -6.2 |
| Ex.2 | 5.83E-07 | 2.15E-012 | 0.01 | 7.7 |
| Ex.3 | 3.85E-08 | 7.43E-012 | 0.0016 | -7.6 |

Experimental Example 2

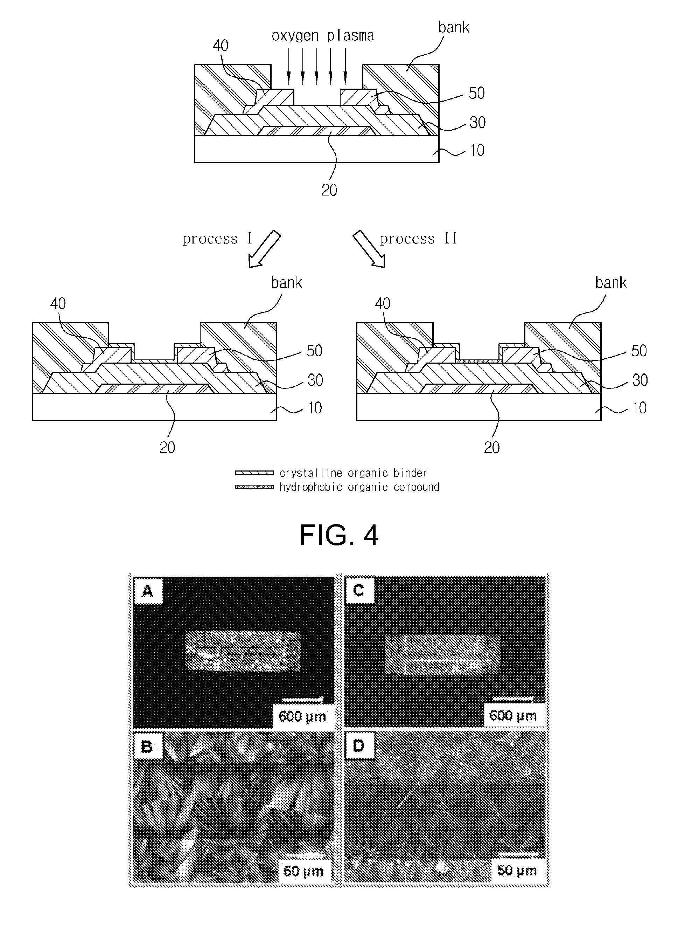

The crystalline structure of the OTFTs manufactured in Examples 2 and 3 was observed using a polarization microscope. The polarization micrograph of the interface between the electrode and the organic semiconductor layer of the OTFTs of Examples 2 and 3 is shown in FIGS. 4A to 4D. FIG. 4A is a polarization micrograph illustrating the OTFT obtained in Example 2, and FIG. 4B is an enlarged micrograph of FIG. 4A. FIG. 4C is a polarization micrograph illustrating the OTFT obtained in Example 3, and FIG. 4D is an enlarged micrograph of FIG. 4C.

As is apparent from FIGS. 4A to 4D, the crystalline morphology (spherulites: polycrystalline structure) of the crystalline organic binder layer of the OTFT according to example embodiments may be observed.

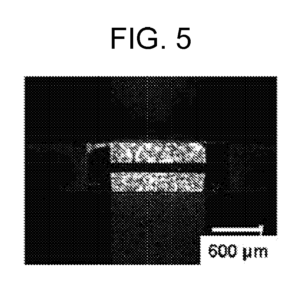

FIG. 5 is a polarization micrograph of the crystalline organic binder selectively applied on the electrode in Example 2. From the micrograph of FIG. 5, the organic binder film may be selectively applied only on the channel portion between the source electrode and the drain electrode. As described hereinbefore, example embodiments provide an OTFT having improved interface properties and a method of manufacturing the same. According to example embodiments, a functional organic nano binder, which is crystalline, may be selectively applied on the surface of an organic insulating layer and source/drain electrodes or on the surface of the source/drain electrodes, thereby controlling the crystal orientation of the organic semiconductor in the OTFT and the contact resistance between the organic semiconductor and the electrode, resulting in high-performance OTFTs.

Further, according to example embodiments, the crystal unit lattice and functional group of the organic binder may be precisely controlled, thus realizing two-dimensional geometric lattice matching between the crystalline organic binder and the crystalline organic semiconductor. Thereby, the crystal orientation of the organic semiconductor and the interface interaction force may be precisely controlled at the interface between the insulating layer and the organic semiconductor layer or between the electrode and the organic semiconductor layer, consequently improving the device properties of the OTFT. Furthermore, according to example embodiments, the crystalline organic binder may be applied to all electrodes, regardless of the type of material of the electrode, unlike conventional interlayer materials, which may be applied only to specific types of electrode, thereby improving processability.

Although example embodiments have been disclosed for illustrative purposes, those skilled in the art will appreciate that various modifications, additions and substitutions are possible, without departing from the scope of the accompanying claims.

**Claims**

1. An organic thin film transistor, comprising a substrate, a gate electrode, an organic insulating layer, source/drain electrodes, an organic semiconductor layer, and a crystalline organic binder layer on a surface of the organic insulating layer and the source/drain electrodes or on the surface of the source/drain electrodes.

2. The organic thin film transistor as set forth in claim 1, wherein the crystalline organic binder layer is formed using a crystalline organic binder having a $C_{5\sim12}$ aromatic backbone constituting a crystalline structure, one end of the backbone having a hydrophilic functional group, and the other end of the backbone having a functional group for controlling a dipole moment.

3. The organic thin film transistor as set forth in claim 2, wherein the aromatic backbone is selected from a group consisting of benzene, naphthalene, anthracene, tetracene, and n-phenylene, wherein n is about 2 - about 6.

4. The organic thin film transistor as set forth in claim 2 or 3, wherein the hydrophilic functional group is selected from a group consisting of -COOH, -SOOH, and -POOOHH.

5. The organic thin film transistor as set forth in claim 2, wherein the functional group for controlling a dipole moment is selected from a group consisting of F, -OH, $-NO_2$, $-NH_2$, -SH, $-CH_3$, -CF, -Cl and a phenyl group.

6. The organic thin film transistor as set forth in any of claims 1-5, wherein the crystalline organic binder is one or more selected from a group consisting of aminobenzoic acid, nitrobenzoic acid, chlorobenzoic acid, fluorobenzoic acid, hydroxybenzoic acid, alkyloxybenzoic acid, alkylbenzoic acid, phenoxybenzoic acid, and iodobenzoic acid.

7. A method of manufacturing an organic thin film transistor including a substrate, a gate electrode, an organic insulating layer, source/drain electrodes, and an organic semiconductor hyer, the method comprising:

   subjecting a surface of the organic insulating layer and the source/drain electrodes, having respective banks, to oxygen plasma treatment; and
   forming a crystalline organic binder layer on the surface subjected to oxygen plasma treatment.

8. The method as set forth in claim 7, wherein forming the crystalline organic binder layer is conducted using a crystalline organic binder having a $C_{5-12}$ aromatic backbone constituting a crystalline structure, one end of the backbone having a hydrophilic functional group, and the other end of the backbone having a functional group for controlling a dipole moment.

9. The method as set forth in claim 7 or 8, wherein forming the crystalline organic binder layer is conducted by applying a hydrophilic crystalline organic binder coating solution, including the crystalline organic binder and a hydrophilic solvent, and then drying the crystalline organic binder layer.

10. The method as set forth in claim 7, 8 or 9, further comprising:

    subjecting the surface of the organic insulating layer to surface treatment using a hydrophobic compound before a surface treatment using the crystalline organic binder.

11. The method as set forth in claim 8, wherein the aromatic backbone is selected from a group consisting of benzene, naphthalene, anthracene, tetracene, and n-phenylene, wherein n is about 2 - about 6.

12. The method as set forth in claim 8, wherein the hydrophilic functional group is selected from a group consisting of -COOH, -SOOH, and -POOOHH.

13. The method as set forth in claim 8, wherein the functional group for controlling a dipole moment is selected from a group consisting of F, -OH, $-NO_2$, $-NH_2$, -SH, $-CH_3$, -CF, -Cl and a phenyl group.

14. The method as set forth in any of claims 8-13, wherein the crystalline organic binder is one or more selected from a group consisting of aminobenzoic acid, nitrobenzoic acid, chlorobenzoic acid, fluorobenzoic acid, hydroxybenzoic acid, alkyloxybenzoic acid, alkylbenzoic acid, phenoxybenzoic acid, and iodobenzoic acid.

15. The method as set forth in claim 9, wherein the hydrophilic solvent is one or more selected from a group consisting of water, alcohol, acetonitrile, and chloroform.

# FIG. 1a

# FIG. 1b

# FIG. 1c

FIG. 2

FIG. 3

oxygen plasma

40

bank

50

30

10

20

process I    process II

40    bank

50

30

10

20

40    bank

50

30

10

20

crystalline organic binder
hydrophobic organic compound

# FIG. 4

A    C

600 μm    600 μm

B    D

50 μm    50 μm

## FIG. 5

600 µm

FIG. 6